# EUROPEAN PATENT SPECIFICATION

(11) **EP 4 474 093 B1**
(45) Date of publication and mention of the grant of the patent: **17.12.2025**
(21) Application number: 24163321.3
(22) Date of filing: 13.03.2024
(51) Int. Cl.: B23K 1/00, B23K 1/005, B23K 1/20, H05K 3/34

(54) **SOLDER SOLDERING METHOD USING LASER**
LÖTVERFAHREN UNTER VERWENDUNG EINES LASERS
PROCÉDÉ DE BRASAGE TENDRE UTILISANT UN LASER

(30) Priority: 09.06.2023 KR 20230074352
(43) Date of publication of application: 11.12.2024
(73) Proprietor: S.S.P. Inc., Incheon Incheon 21999 (KR)
(72) Inventor: Ju, Heui-Jong, 22003 Yeonsu-gu, Incheon (KR)
(74) Representative: Petraz, Gilberto Luigi

(56) References cited:
- WO-A1-2018/212087
- WO-A2-2004/057648
- DE-A1- 102007 040 214
- JP-A- H02 114 696
- JP-B2- 4 830 635
- US-A1- 2022 410 298

## Description

### CROSS REFERENCE TO RELATED APPLICATION

The present application claims priority to Korean Patent Application No. 10-2023-0074352, filed June 9, 2023.

### BACKGROUND OF THE INVENTION

### Field of the Invention

The present disclosure relates to a solder soldering method using a laser. More particularly, the present disclosure relates to a solder soldering method using a laser, the solder soldering method performing solder soldering within a few seconds by using the laser so that warpage that occurs due to a difference in a coefficient of thermal expansion between a chip and a substrate is capable of being reduced, thermal shock that occurs on the chip (a component and so on) and the substrate is capable of being reduced, an entire process time is capable of being reduced, and an uneven solder processing temperature is capable of being reduced.

### Description of the Related Art

In an existing semiconductor manufacturing process or an existing PCB manufacturing process, in order to perform an electrical connection between a substrate and solder (a solder ball, a bump, a copper pillar, a solder paste, and so on), the substrate is attached to the solder by using a Mass Reflow (MR) that is a classical hot air method in which a high temperature heat source is applied inside a structure such as an oven and by using an IR lamp and so on as a heat source.

In a simplified description, it can be said that the existing processes are performed such that the solder is melted and solidified by exposing all the chip and the substrate to the high temperature for a long time.

However, such methods take a long time, and since heat is applied to the chip (the component and so on) and to the entire substrate, there is a high possibility that a thermal deformation phenomenon and a package warpage phenomenon will occur.

The package warpage is a phenomenon caused by a difference in the Coefficient of Thermal Expansion (CTE) between the chip and the substrate, which causes many problems in a process that is performed at a later stage.

Patent document 2 forms the basis for the preamble of claim 1 and discloses a laser reflow apparatus and laser reflow method.

Patent document 3 discloses a reflow soldering method and device thereof.

Patent document 4 discloses a soldering method and soldering equipment.

Patent document 5 discloses a localized reflow for wire bonding and flip chip connections.

### Document of Related Art

(Patent Document 1) Korean Patent Application Publication No. 10-2022-0083629 (published on June 20, 2022).
(Patent Document 2) US Patent Application No. 2022/410298 (published on December 29, 2022).
(Patent Document 3) Japanese Patent Application No. H02114696 (published on April 26, 1990.
(Patent Document 4) Japanese Patent No. 4830635 (published on December 7, 2011).
(Patent Document 5) International Patent Application No. 2004/057648 (published on July 8, 2024).

### SUMMARY OF THE INVENTION

Accordingly, the present disclosure has been made keeping in mind the above problems occurring in the related art, and an objective of the present disclosure is to provide a solder soldering method using a laser, the solder soldering method performing solder soldering within a few seconds by using the laser so that warpage that occurs due to a difference in a coefficient of thermal expansion between a chip and a substrate is capable of being reduced, and thermal shock that occurs on the chip (a component and so on) and the substrate is capable of being reduced.

In addition, another objective of the present disclosure is to provide a solder soldering method using a laser, the solder soldering method being performed such that the laser irradiation is performed after upper and lower portions of a substrate are simultaneously preheated while the substrate and solder that are supplied to a base are moved to a laser irradiation portion, thereby being capable of reducing an entire process time and also being capable of preventing defects due to an uneven solder processing temperature.

In order to solve these problems, in the present invention, there is provided a solder soldering method using a laser according to the appended claims, the solder soldering method including: a supplying process in which a substrate having solder positioned on an upper portion of the substrate is supplied to an upper portion of a substrate fixing member that constitutes a soldering apparatus; a preheating process in which the substrate and the solder are preheated while the substrate is moved together with the substrate fixing member; an attachment process in which the upper portion of the substrate is irradiated with the laser so that the solder is melted and attached to the upper portion of the substrate; and a discharging process in which the substrate having the solder attached to the substrate is moved to a tray.

Here, in the preheating process, a lower portion of the substrate may be heated to a set temperature by a lower heater provided in the soldering apparatus, and the upper portion of the substrate and the solder may be heated to a set temperature by an upper heater provided in an upper portion of the soldering apparatus.

At this time, an adsorption portion for adsorbing a lower surface of the substrate may be formed in the substrate fixing member, an inner portion of the adsorption portion may maintain a set vacuum level, and gas contained inside the adsorption portion may be heated to a temperature equal to or more than a set temperature.

In addition, in the attachment process, a first mask configured to prevent the laser irradiating an edge of the substrate is used, the first mask includes a blocking portion configured to block the laser irradiation, and the first mask includes a heat dissipation portion which is in contact with the upper surface of the substrate and which is configured to discharge excessive heat. The blocking portion is formed of a material having a low thermal conductivity and the heat dissipation portion is formed of a metal or a ceramic type material having a good thermal conductivity.

Here, in the attachment process, a second mask for protecting a chip mounted on the substrate from the laser may be further provided between the substrate and a laser irradiation portion, the second mask may include a transparent plate formed of a transparent material through which the laser is capable of being transmitted, and the second mask may include a masking portion which is formed on a first side of the transparent plate so as to correspond to a position of the chip mounted on the substrate and which is configured to block the laser.

According to the present disclosure described above, since solder soldering is performed within a few seconds by using the laser, warpage that occurs due to a difference in a coefficient of thermal expansion between the chip and the substrate is capable of being reduced, and thermal shock that occurs on the chip (the component and so on) and the substrate is capable of being reduced.

In addition, in the present disclosure, since the laser irradiation is performed after the upper and lower portions of the substrate are simultaneously preheated while the substrate and the solder that are supplied to the base are moved to the laser irradiation portion, the entire process time is capable of being reduced, and also defects due to an uneven solder processing temperature are capable of being prevented.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a flowchart illustrating a solder soldering method using a laser according to the present disclosure;
FIG. 2 is a conceptual view illustrating a preheating process of the solder soldering method using the laser according to the present disclosure;
FIG. 3 is a conceptual view illustrating an attachment process of the solder soldering method using the laser according to the present disclosure;
FIG. 4 is a conceptual view illustrating the use of a second mask in the attachment process of the solder soldering method using the laser according to the present disclosure; and
FIG. 5 is a conceptual view illustrating a state in which a masking portion of the second mask blocks a laser irradiating a chip of a substrate during the attachment process of the solder soldering method using the laser according to the present disclosure.

### DETAILED DESCRIPTION OF THE INVENTION

Hereinafter, an exemplary embodiment of the present disclosure will be described in detail with reference to the accompanying drawings. The same constituent elements in the drawings are denoted by the same reference numerals, and a repeated description of the same elements will be omitted. In addition, it should be understood that the present disclosure may be implemented in many different forms and is not limited to the described embodiments.

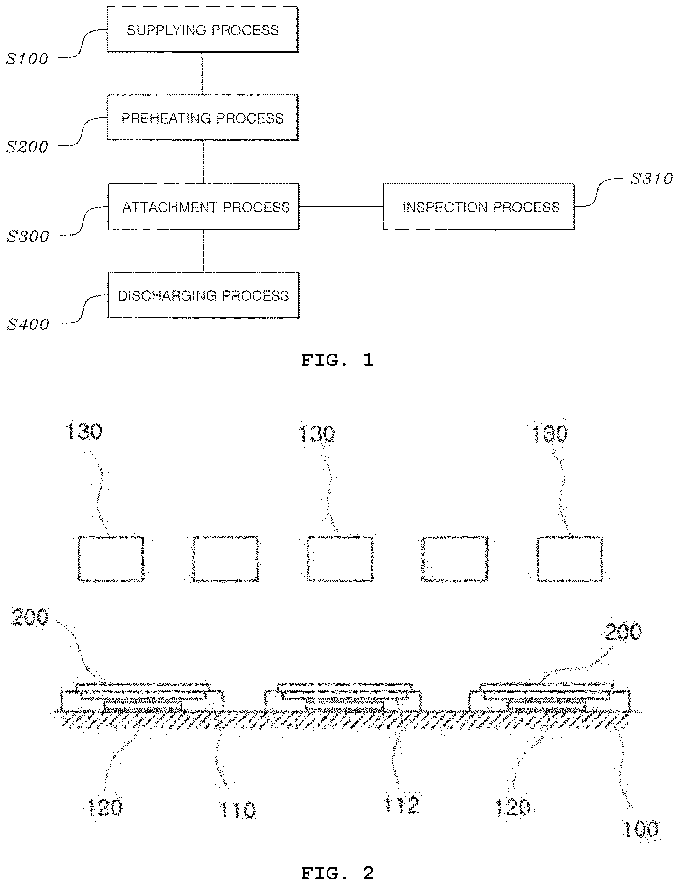

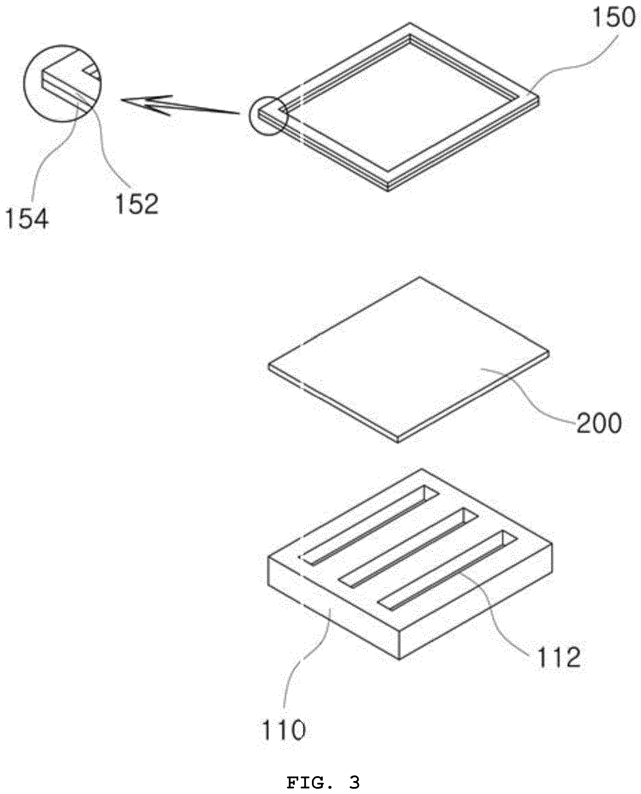

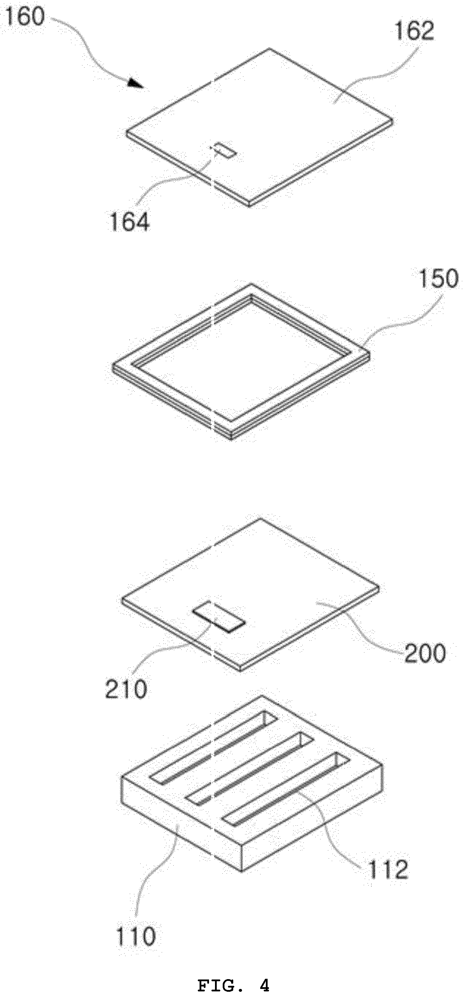

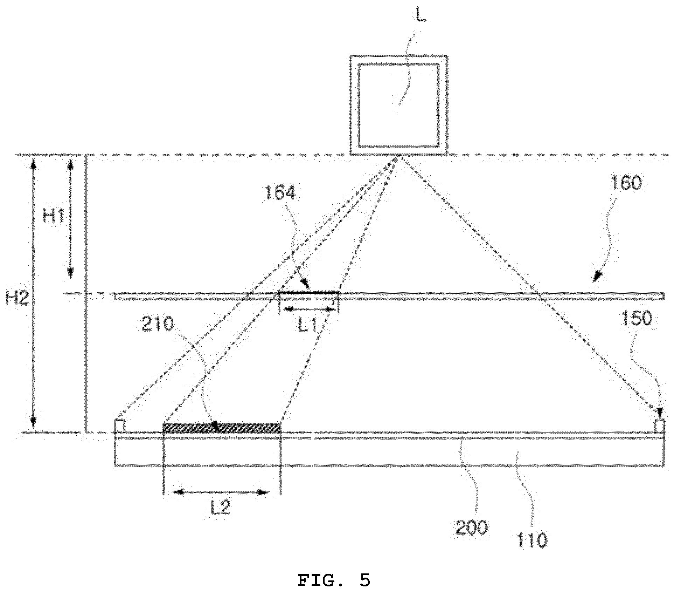

FIG. 1 is a flowchart illustrating a solder soldering method using a laser according to the present disclosure, FIG. 2 is a conceptual view illustrating a preheating process of the solder soldering method using the laser according to the present disclosure, FIG. 3 is a conceptual view illustrating an attachment process of the solder soldering method using the laser according to the present disclosure, FIG. 4 is a conceptual view illustrating the use of a second mask in the attachment process of the solder soldering method using the laser according to the present disclosure, and FIG. 5 is a conceptual view illustrating a state in which a masking portion of the second mask blocks a laser irradiating a chip of a substrate during the attachment process of the solder soldering method using the laser according to the present disclosure.

The present disclosure relates to a solder soldering method using a laser. As illustrated in FIG. 1 to FIG. 4, the solder soldering method includes a supplying process S100 in which a substrate 200 having solder (not illustrated) positioned on an upper portion thereof is supplied to an upper portion of a substrate fixing member 110 that constitutes a soldering apparatus, a preheating process S200 in which the substrate 200 and the solder are preheated while the substrate 200 is moved together with the substrate fixing member 110, an attachment process S300 in which the upper portion of the substrate 200 is irradiated with the laser so that the solder is melted and attached to the upper portion of the substrate 200, and a discharging process S400 in which the substrate 200 having the solder attached thereto is moved to a tray.

Here, in the solder soldering apparatus used in the present disclosure, the substrate fixing member 110 is provided on an upper portion of a base 100, and is moved by a separate moving apparatus (not illustrated) such that each process is capable of being performed.

Therefore, in the present disclosure, since the upper portion of the substrate 200 is irradiated with the laser, the solder is capable of being rapidly heated equal to or more than a melting point of the solder and the solder is capable of being rapidly attached to the upper portion of the substrate 200, so that the time required for the entire process may be reduced.

In addition, in the supplying process S100, the substrate 200 is discharged from a substrate storage apparatus (not illustrated) such as a magazine, a cassette, and so on that are provided separately, and the substrate 200 is supplied to the upper portion of the substrate fixing member 110.

At this time, when the substrate 200 is seated on the upper portion of the substrate fixing member 110, a processing area on the substrate 200 and an irradiation position of a laser beam are matched by using a Pattern Recognition System (PRS) or a mechanical alignment method, so that the solder may be stably attached to the upper portion of the substrate 200 in the attachment process S300.

Meanwhile, after the supplying process S100 is completed, the substrate 200 is moved to a position where the attachment process S300 is performed while the solder is in a state in which the solder is seated on the upper portion of the substrate 200, and the preheating process S200 in which the substrate 200 and the solder are preheated to a set temperature is performed during the moving process.

Here, in the preheating process S200, a lower portion of the substrate 200 is heated to the set temperature by a lower heater 120 provided in the soldering apparatus, and the upper portion of the substrate 200 and the solder are heated to the set temperature by an upper heater 130 provided in an upper portion of the soldering apparatus.

At this time, the lower heater 120 is configured to heat the lower portion of the substrate 200 which is mounted inside the substrate fixing member 110 and which is fixed to the upper portion of the substrate fixing member 110 to 70 degrees Celsius to 90 degrees Celsius, and the upper heater 130 is configured to heat the substrate 200 moving the upper portion of the base 100 and the upper portion of the solder to 95 degrees Celsius to 105 degrees Celsius.

In addition, an adsorption portion 112 for adsorbing a lower surface of the substrate 200 is formed in the substrate fixing member 110, and an inner portion of the adsorption portion 112 maintains a set vacuum level, thereby solidly fixing the substrate 200 positioned on an upper portion of the adsorption portion 112.

Here, the adsorption portion 112 is formed in a hole shape or a groove shape, and is configured to adsorb the lower portion of the substrate 200 seated on the upper portion of the adsorption portion 112. The substrate fixing member 110 is formed of a material having a predetermined elastic force, and the substrate 200 is pressed by a set pressure in the supplying process S100, so that air inside the adsorption portion 112 is discharged to the outside, thereby forming the set vacuum level.

At this time, the lower heater 120 is provided inside the substrate fixing member 110 as described above, and is configured to heat gas contained inside the adsorption portion 112 to the set temperature.

Therefore, the upper heater 130 and the lower heater 120 heat the upper and lower portions of the substrate 200 and the solder as well as the gas contained inside the adsorption portion 112 to the set temperature, so that heat transfer (loss) to the lower portion of the substrate 200 may be prevented when the laser irradiation is performed and the substrate 200 and the solder are heated in the attachment process S300 to be described later.

That is, when the temperature of the lower portion of the substrate 200 is low or the temperature of the gas contained inside the adsorption portion 112 is low, heat loss occurs while the laser irradiation is performed during the attachment process S300 due to a phenomenon in which heat is transferred to the lower portion of the substrate 200 through an I/O circuit pad in the substrate 200. Furthermore, a difference in the amount of heat transfer to the lower portion occurs since a metal density of a connection portion is different for each I/O circuit pad, so that the temperature of the entire solder is not maintained uniformly and defects occur.

Therefore, as described above, in the present disclosure, the substrate 200, the solder, and also the gas contained in the adsorption portion 112 are preheated through the preheating process S200, so that heat loss may be prevented in the attachment process S300 and the temperature of the entire solder may be maintained uniformly, thereby preventing defects.

In addition, when the substrate fixing member 110 is formed of a hard material, although not illustrated in the drawings, a through-hole in communication with the outside is formed in the adsorption portion 112 that is formed in the hole shape or the groove shape, and an adsorption apparatus (not illustrated) provided at the outside is connected to the through-hole and is configured to maintain the inside of the adsorption portion 112 at the set vacuum level.

Meanwhile, in the attachment process S300, the solder is melted by the laser irradiating the upper portion of the substrate 200 fixed to the upper portion of the substrate fixing member 110. In the attachment process S300, as illustrated in FIG. 3, a first mask 150 configured to prevent the laser irradiating an edge of the substrate 200 is used, so that the edge of the substrate 200 is capable of being prevented from being damaged by heat.

Here, the first mask 150 is formed in a frame shape and is configured such that the laser irradiating the edge of the substrate 200 is blocked but the laser irradiating the center portion of the substrate 200 is allowed, thereby allowing the solder to be rapidly melted so that the solder is attached to an upper portion of the substrate 200.

At this time, the first mask 150 includes a blocking portion 152 which is positioned on an upper portion of the first mask 150 and which is configured to block the laser irradiation, and includes a heat dissipation portion 154 which is in contact with the upper surface of the substrate 200 and which is configured to discharge excessive heat. The blocking portion 152 is formed of a material having a low thermal conductivity, and the heat dissipation portion 154 is formed of a metal or a ceramic type material having a good thermal conductivity.

Therefore, since the laser irradiating the edge of the substrate 200 is blocked and also heat conducted from the center portion of the substrate 200 is discharged from the heat dissipation portion 154 to the outside, so that a situation in which heat is gathered to the edge of the substrate 200 and a polymer constituting the substrate 200 is damaged by heat may be prevented.

In addition, as described above, the process of the present disclosure may be performed while a chip 210 and so on are not separately mounted on the upper surface of the substrate 200. However, as illustrated in FIG. 4, in the attachment process S300, a second mask 160 for protecting the chip 210 mounted on the substrate 200 from the laser may be further provided between the substrate 200 and a laser irradiation portion (not illustrated).

Here, the second mask 160 includes a transparent plate 162 formed of a transparent material (Quartz, Znse, Borosilca, Fused Sillica, and so on) through which the laser is capable of being transmitted, and includes a masking portion 164 which is formed on a first side of the transparent plate 162 so as to correspond to a position of the chip 210 mounted on the substrate 200 and which is specially and optically treated so as to block the laser.

At this time, in the attachment process S300, a lifting apparatus (not illustrated) provided on a first side of the base 100 is controlled so that the first mask 150 is in contact with the edge of the substrate 200 and the second mask 160 is moved to a set height, and then the laser irradiates the upper surface of the substrate 200.

Therefore, by the first mask 150 and the masking portion 164 of the second mask 160, the laser does not irradiate the edge of the substrate 200 and does not irradiate the chip 210, so that defects may be prevented from occurring.

At this time, a length L1 of the masking portion 164 of the second mask 160, a height H1 of the second mask 160 from a laser head L, a length L2 of the chip 210 of the substrate 200, and a height H2 of the substrate 200 from the laser head L satisfy the equation L1:L2 = H1:H2, so that an area of the laser blocked by the masking portion 164 of the second mask 160 may match an area of the chip 210.

After the solder is stably attached to the upper surface of the substrate 200 through the attachment process S300, the discharging process S400 is performed. In the discharging process S400, the substrate 200 to which the solder is attached is discharged to the separately provided tray (not illustrated) by a separate discharging apparatus (not illustrated).

Meanwhile, in the attachment process S300, an inspection process S310 for determining whether the substrate 200 to which the solder is attached is defective may further be performed. In the inspection process S310, the temperature of the upper surface of the substrate 200 is detected through a temperature sensor (not illustrated) provided on a side portion of the laser irradiation portion, thereby determining whether the substrate 200 is defective.

Here, an infrared sensor, a thermal infrared camera, and so on that are capable of measuring temperature in a non-contact manner may be used as the temperature sensor. Conventionally, the melting point of lead-free solder is 217 degrees Celsius. In this situation, the temperature of the substrate 200 is determined to be 240 degrees Celsius to 350 degrees Celsius as an appropriate temperature.

Therefore, when the temperature detected by the temperature sensor during the attachment process S300 is within the set temperature range, the substrate 200 is determined as a good product. When the temperature is outside the set temperature range, the substrate 200 is determined as a defective product.

Of course, a normal temperature range may vary according to a solder material.

Although the exemplary embodiment of the present disclosure has been described above, the scope of the present disclosure is not limited thereto. The scope of the rights of the present disclosure extends to those that are substantially equivalent to the embodiments of the present disclosure, and various modifications may be made by those skilled in the art to which the present disclosure pertains without departing from the scope of the present disclosure as defined in the appended claims.

### Industrial Applicability

The present disclosure relates to a solder soldering method using a laser. More particularly, the present disclosure relates to a solder soldering method using a laser, the solder soldering method performing solder soldering within a few seconds by using the laser so that warpage that occurs due to a difference in a coefficient of thermal expansion between a chip and a substrate is capable of being reduced, thermal shock that occurs on the chip (a component and so on) and the substrate is prevented, an entire process time is reduced, and defects due to an uneven solder processing temperature are prevented.

## Claims

1. A solder soldering method using a laser, the solder soldering method comprising:
a supplying process (S100) in which a substrate (200) having solder positioned on an upper portion of the substrate is supplied to an upper portion of a substrate fixing member (110) that constitutes a soldering apparatus;
a preheating process (S200) in which the substrate (200) and the solder are preheated while the substrate (200) is moved together with the substrate fixing member (110);
an attachment process (S300) in which the upper portion of the substrate (200) is irradiated with the laser so that the solder is melted and attached to the upper portion of the substrate (200); and
a discharging process (S400) in which the substrate (200) having the solder attached to the substrate is moved to a tray; wherein
in the attachment process (S300), a first mask (150) configured to prevent the laser irradiating an edge of the substrate (200) is used, the first mask (150) includes a blocking portion (152) configured to block the laser irradiation,
the method being **characterized in that**
the first mask (150) includes a heat dissipation portion (154) which is in contact with the upper surface of the substrate (200) and which is configured to discharge excessive heat, and
wherein the blocking portion (152) is formed of a material having a low thermal conductivity, and the heat dissipation portion (154) is formed of a metal or a ceramic type material having a good thermal conductivity.

2. The solder soldering method of claim 1, wherein, in the preheating process (S200), a lower portion of the substrate (200) is heated to a set temperature by a lower heater (120) provided in the soldering apparatus, and the upper portion of the substrate (200) and the solder are heated to a set temperature by an upper heater (130) provided in an upper portion of the soldering apparatus.

3. The solder soldering method of claim 1, wherein an adsorption portion (112) for adsorbing a lower surface of the substrate (200) is formed in the substrate fixing member (110), an inner portion of the adsorption portion (112) maintains a set vacuum level, and gas contained inside the adsorption portion (112) is heated to a temperature equal to or more than a set temperature.

4. The solder soldering method of claim 1, wherein, in the attachment process (S300), a second mask (160) for protecting a chip (210) mounted on the substrate (200) from the laser is further provided between the substrate (200) and a laser irradiation portion, and
the second mask (160) includes a transparent plate (162) formed of a transparent material through which the laser is capable of being transmitted, and includes a masking portion (164) which is formed on a first side of the transparent plate (162) so as to correspond to a position of the chip (210) mounted on the substrate (200) and which is configured to block the laser.

## Patentansprüche

1. Lötmittel-Lötverfahren unter Verwendung eines Lasers, wobei das Lötverfahren Folgendes umfasst:
einen Zuführschritt (S100), in dem ein Substrat (200), auf dessen einem oberem Abschnitt Lötmittel angeordnet ist, einem oberen Abschnitt eines Substratfixierungselements (110) zugeführt wird, das eine Lötvorrichtung bildet;
einen Vorheizschritt (S200), in dem das Substrat (200) und das Lötmittel vorgeheizt werden, während das Substrat (200) zusammen mit dem Substratfixierungselement (110) bewegt wird;
einen Anbringungsschritt (S300), in dem der obere Abschnitt des Substrats (200) mit dem Laser bestrahlt wird, sodass das Lötmittel geschmolzen und an dem oberen Abschnitt des Substrats (200) angebracht wird; und
einen Entladungsschritt (S400), in dem das Substrat (200), an dem das Lötmittel an dem Substrat angebracht ist, zu einem Tray bewegt wird; wobei
in dem Anbringungsschritt (S300) eine erste Maske (150) verwendet wird, die so ausgebildet ist, dass sie verhindert, dass der Laser einen Rand des Substrats (200) bestrahlt, wobei die erste Maske (150) einen Blockierabschnitt (152) umfasst, der so ausgebildet ist, dass er die Laserbestrahlung blockiert,
wobei das Verfahren **dadurch gekennzeichnet ist, dass**
die erste Maske (150) einen Wärmeabfuhrabschnitt (154) umfasst, der mit der oberen Oberfläche des Substrats (200) in Kontakt steht und so ausgebildet ist, dass er überschüssige Wärme abführt,
wobei der Blockierabschnitt (152) aus einem Material mit geringer Wärmeleitfähigkeit gebildet ist und der Wärmeabfuhrabschnitt (154) aus einem metallischen oder keramischen Material mit guter Wärmeleitfähigkeit gebildet ist.

2. Lötmittel-Lötverfahren nach Anspruch 1, wobei in dem Vorheizschritt (S200) ein unterer Abschnitt des Substrats (200) durch einen in der Lötvorrichtung vorgesehenen unteren Heizer (120) auf eine Solltemperatur erhitzt wird und der obere Abschnitt des Substrats (200) und das Lötmittel durch einen in einem oberen Abschnitt der Lötvorrichtung vorgesehenen oberen Heizer (130) auf eine Solltemperatur erhitzt werden.

3. Lötmittel-Lötverfahren nach Anspruch 1, wobei in dem Substratfixierungselement (110) ein Adsorptionsabschnitt (112) zum Adsorbieren einer unteren Oberfläche des Substrats (200) ausgebildet ist, wobei ein innerer Abschnitt des Adsorptionsabschnitts (112) ein Sollvakuumniveau aufrechterhält und wobei ein im Inneren des Adsorptionsabschnitts (112) enthaltenes Gas auf eine Temperatur gleich oder höher als eine Solltemperatur erhitzt wird.

4. Lötmittel-Lötverfahren nach Anspruch 1, wobei in dem Anbringungsschritt (S300) zwischen dem Substrat (200) und einem Laserbestrahlungsabschnitt zusätzlich eine zweite Maske (160) vorgesehen ist, um einen auf dem Substrat (200) montierten Chip (210) vor dem Laser zu schützen, und
wobei die zweite Maske (160) eine transparente Platte (162) umfasst, die aus einem transparenten Material gebildet ist, durch das der Laser hindurchtreten kann, und einen Maskierungsabschnitt (164) umfasst, der auf einer ersten Seite der transparenten Platte (162) so ausgebildet ist, dass er einer Position des auf dem Substrat (200) montierten Chips (210) entspricht, und der so ausgebildet ist, dass er den Laser blockiert.

## Revendications

1. Procédé de soudure à l'aide d'un laser, le procédé de soudure comprenant :
un processus de fourniture (S100) dans lequel un substrat (200) présentant une soudure positionnée sur une partie supérieure du substrat est fourni à une partie supérieure d'un élément de fixation (110) de substrat qui constitue un appareil de soudure ;
un processus de préchauffage (S200) dans lequel le substrat (200) et la soudure sont préchauffés tandis que le substrat (200) est déplacé avec l'élément de fixation (110) de substrat ;
un processus de fixation (S300) dans lequel la partie supérieure du substrat (200) est irradiée avec le laser de sorte que la soudure soit fondue et fixée à la partie supérieure du substrat (200) ; et
un processus de décharge (S400) dans lequel le substrat (200) présentant la soudure fixée au substrat est déplacé vers un plateau ; dans lequel dans le processus de fixation (S300), un premier masque (150) configuré pour empêcher le laser d'irradier un bord du substrat (200) est utilisé, le premier masque (150) comprend une partie de blocage (152) configurée pour bloquer l'irradiation laser, le procédé étant **caractérisé en ce que** le premier masque (150) comprend une partie de dissipation de chaleur (154) qui est en contact avec la surface supérieure du substrat (200) et qui est configurée pour évacuer une chaleur excessive, et
dans lequel la partie de blocage (152) est formée d'un matériau présentant une faible conductivité thermique, et la partie de dissipation de chaleur (154) est formée d'un matériau de type métal ou céramique présentant une bonne conductivité thermique.

2. Procédé de soudure selon la revendication 1, dans lequel, dans le processus de préchauffage (S200), une partie inférieure du substrat (200) est chauffée à une température définie par un dispositif de chauffage inférieur (120) prévu dans l'appareil de soudure, et la partie supérieure du substrat (200) et la soudure sont chauffées à une température définie par un dispositif de chauffage supérieur (130) prévu dans une partie supérieure de l'appareil de soudure.

3. Procédé de soudure selon la revendication 1, dans lequel une partie d'adsorption (112) pour adsorber une surface inférieure du substrat (200) est formée dans l'élément de fixation de substrat (110), une partie intérieure de la partie d'adsorption (112) maintient un niveau de vide défini, et le gaz contenu à l'intérieur de la partie d'adsorption (112) est chauffé à une température égale ou supérieure à une température définie.

4. Procédé de soudure selon la revendication 1, dans lequel, dans le processus de fixation (S300), un second masque (160) pour protéger une puce (210) montée sur le substrat (200) du laser est en outre prévu entre le substrat (200) et une partie d'irradiation laser, et
le second masque (160) comprend une plaque transparente (162) formée d'un matériau transparent à travers lequel le laser peut être transmis, et comprend une partie de masquage (164) qui est formée sur un premier côté de la plaque transparente (162) de manière à correspondre à une position de la puce (210) montée sur le substrat (200) et qui est configurée pour bloquer le laser.
